# EUROPÄISCHE PATENTSCHRIFT

(11) **EP 2 134 046 B1**
(45) Veröffentlichungstag und Bekanntmachung des Hinweises auf die Patenterteilung: **03.08.2016**
(21) Anmeldenummer: 09007326.3
(22) Anmeldetag: 03.06.2009
(51) Int. Cl.: H04L 25/06, H03K 5/08

(54) **Wandlerschaltung zum Umwandeln eines empfangenen seriellen Analogsignales in den weiterzuverarbeitenden Bitstrom eines Digitalsignales**
Conversion circuit for converting a received serial analogue signal into the bit stream of a digital signal for further processing
Circuit convertisseur destiné à convertir un signal analogique série reçu dans le flux de bits d'un signal numérique à traiter

(30) Priorität: 10.06.2008 DE 102008027564
(43) Veröffentlichungstag der Anmeldung: 16.12.2009
(73) Patentinhaber: Diehl Metering Systems GmbH, 90451 Nürnberg (DE)
(72) Erfinder: Becke, Gerhard, 91301 Forchheim (DE)
(74) Vertreter: Diehl Patentabteilung

(56) Entgegenhaltungen:
- WO-A1-01/82539
- US-B2- 7 091 793

## Beschreibung

Die Erfindung betrifft eine Wandlerschaltung gemäß dem Oberbegriff des Hautanspruches.

Um ein empfangenes binär impulsamplitudenmoduliertes Analogsignal in ein weiterzuverarbeitendes Digitalsignal umzuwandeln, muss mittels eines Schwellwertkriteriums eine Entscheidung darüber getroffen werden, welche der Impulse im Analogsignal wegen beispielsweise hoher Amplitude den logischen Wert EINS (I), und welche demzufolge den Wert NULL (0) wegen weniger hoher Amplitude, repräsentieren. Aufgrund der Einflüsse des Übertragungsmediums ist diese Binärdynamik im Analogsignal aber nicht zeitlich konstant, so dass insbesondere bei geringem Amplitudenunterschied und in, etwa wegen Funkempfangs über größere Entfernungen oder bei Betrieb mit geringer Sendeleistung, verrauschter Signalumgebung erhebliche Fehler bei solcher Analog-Digital-Wandlung auftreten können, wenn die A-D-Wandlung, also die I-0-Diskrimination mit schaltungstechnisch fest vorgegebener Triggerschwelle durchgeführt wird.

Es ist deshalb bekannt, aus dem Pegel der Impulsfolge des in einem Telegramm vor seinem Block mit den Nutzdaten enthaltenen Vorspanns (Headers) - wenn er denn lang genug dafür ansteht - einen aktuellen Amplituden-Mittelwert herauszufiltern und diesen zum Triggerwert für die I-0-Diskrimination des unmittelbar folgenden Nutzdatenblockes zu verarbeiten. Über dessen Länge können die Übertragungsbedingungen sich aber schon wieder ändern, weshalb für gültige Impulse mit erheblichen Sicherheitsspannen beiderseits der Triggerschwelle gearbeitet werden muss. Das beschränkt den Einsatz derartiger Wandlerschaltungen in der Praxis auf gute Funkübertragungsverhältnisse, also auf solche mit hoher Spannungsdynamik im empfangenen Analogsignal wegen starker Modulation bei hoher Sendeleistung oder wegen geringer Senderentfernung.

Aus der WO 01/82539 A1 ist es bekannt, die Triggerschwelle dem Signal nachzuführen, wobei bei einer hohen Signalamplitude eine schnellere, d. h. über ein geringe Zahl von Messpunkten gemittelte, Nachführung der Triggerschwelle erfolgt, während bei einer geringeren Amplitude eine langsamere, d. h. über eine größere Anzahl von Messwerten gemittelte, Nachführung vorgenommen wird.

Die US 7,091,793 B2 beschreibt eine variable Anpassung der Triggerschwelle an die Stärke des elektrischen Signals, wobei die Triggerschwelle derart verändert wird, dass das Verhältnis zwischen Triggeschwelle und Signalstärke gleich bleibt

In Erkenntnis dieser Gegebenheiten liegt vorliegender Erfindung die technische Problemstellung zugrunde, ohne wesentlichen schaltungstechnischen Mehraufwand die Analog-Digital-Wandlung zuverlässiger zu machen und dadurch bei gegebener Sendeleistung größere Distanzen überbrücken zu können. Das ist von besonderem wirtschaftlichen Interesse etwa beim drahtlosen Fernablesen von Energieversorgungs-Messgeräten wie Wärmemengen- oder Wasserverbrauchszählern in Mietwohnungen, die mit miniaturisierten Funkgeräten ausgestattet sind, um vom Berechtigten für die Kostenabrechnung erfasst werden zu können, nämlich ohne Wohnungen betreten zu müssen etwa schon im Zuge eines bloßen Vorbeifahrens an einem Wohnblock.

Jene Aufgabe ist erfindungsgemäß durch die im Hauptanspruch angegebenen wesentlichen Merkmale gelöst. Danach wird die Triggerschwelle nicht mehr für einen kompletten Datenblock einheitlich vorgegeben, sondern für jeden einzelnen der aufeinanderfolgend empfangenen Analogimpulse erneut, je nach den momentanen Übermittlungsgegebenheiten individuell angepasst.

Erfindungsgemäß wird jeder Empfangsimpuls hinsichtlich seines Gleichspannungsanteils vor seiner Amplitudendiskrimination auf die Hälfte des durch die Betriebsspannung gegebenen, maximal auswertbaren Pegels gesetzt. Das liefert wegen größerer Aussteuerungsdynamik insbesondere eine bessere Unabhängigkeit des Digitalisierungsergebnisses von aktuell gegebenen Rauscheinflüssen.

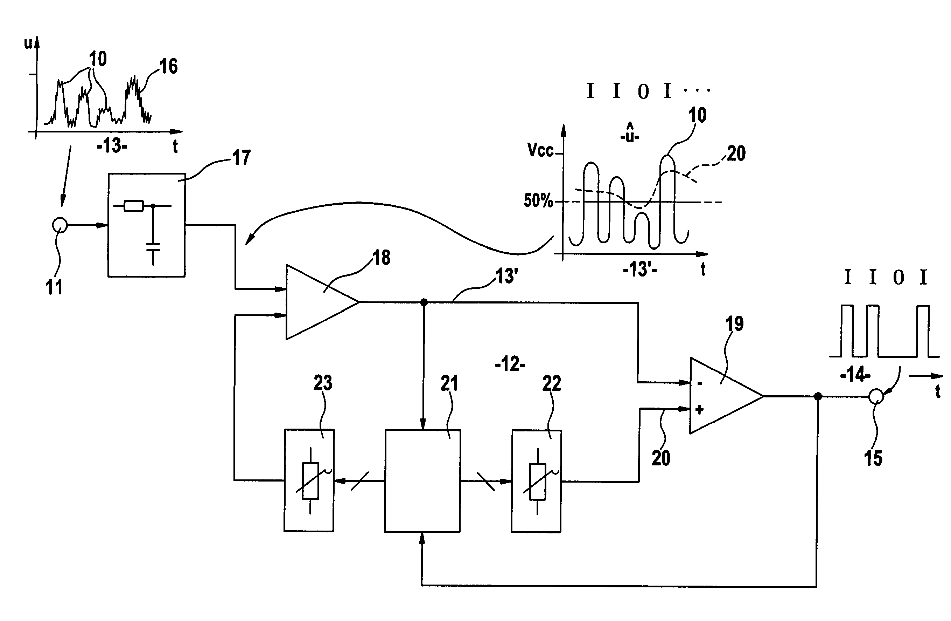

Zusätzliche Abwandlungen und Weiterbildungen zur Erfindung ergeben sich aus den weiteren Ansprüchen und, auch hinsichtlich deren Vorteilen, aus nachstehender Beschreibung eines in der Zeichnung als Blockschaltbild mit den funktionswesentlichen Komponenten abstrahiert skizzierten bevorzugten Ausführungsbeispieles zur erfindungsgemäßen Lösung. Das Schaltbild der Zeichnung zeigt die bitgerechte Triggerschwelleneinstellung für die Analog-Digital-Wandlung gleichspannungssymmetrierter Analogimpulse, ohne Berücksichtigung der Beschaltung der Operationsverstärker und ohne schaltungstechnische Maßnahmen zur Pulsformung.

Am Eingang 11 der skizzierten Wandlerschaltung 12 liegt eine empfangene, im Falle des Funkempfanges demodulierte, Folge von binär amplitudenmodulierten Impulsen 10 als

Analogsignal 13 an, das in das gleichwertige Digitalsignal 14 eines digitalen Bitstromes am Schaltungs-Ausgang 15 umgewandelt werden soll.

In der Praxis sind dem eigentlichen, bereinigten Analogsignal 13' übertragungsbedingt störende hochfrequente Signalkomponenten 16 überlagert. Die werden zweckmäßigerweise in einem Tiefpass 17 aus dem Eingangssignal 13 ausgefiltert. Das Ergebnis stellt das für die Weiterverarbeitung konditionierte Analogsignal 13' dar.

Üblicherweise liegt die I-Amplitude û des Analogsignales 13 nur bei einem Bruchteil der Betriebsspannung Vcc der Operationsverstärker und damit der möglichen Dynamik der Wandlerschaltung 12. In einem Mittelwertsteller 18 wird der Gleichspannungspegel im Analogsignal 13=13' deshalb zweckmäßigerweise durch Spannungsüberlagerung auf möglichst ständig 50% der Betriebsspannung Vcc verschoben und dann mittels interner Verstärkung hierum voll ausgesteuert.

Das Analogsignal 13' ist in einem Komparator 19 gegen eine Triggerschwelle 20 geschaltet. Wenn deren Spannungspegel von der aktuellen Amplitude eines Impulses im Analogsignal 13' überschritten ist, liefert der Komparator 19 (im vorliegenden Beispielsfalle) für den Bitstrom des Digitalsignales 14 am Schaltungs-Ausgang 15 ein Potential des Wertes I, andernfalls des Wertes 0; wie in der Zeichnung oben rechts in Zeitdiagrammen einander gegenübergestellt.

Diese Triggerschwelle 20 für die A-D-Wandlung ist aber weder starr eingestellt, noch für eine bestimmte Informationslänge fest vorgegeben. Vielmehr wird sie erfindungsgemäß für jedes aktuell zu verarbeitende Bit (Impuls 10) im Analogsignal 13/13' neu eingestellt. Dafür wird in einem Mikroprozessor 21, der mit dem Analogsignal 13' beaufschlagt ist, dessen aktuelle Amplitude 10 ermittelt und danach, unter Berücksichtigung maximaler und minimaler Grenzwerte sowie gegebenenfalls der Vorgeschichte, für jeden Analogimpuls zu seiner Analog-Digital-Wandlung optimal eingestellt. Das erfolgt mittels feinstufigen Ansteuerns eines sogen. Digitalpotentiometers 22 durch Umschalten zwischen verschiedenen Widerstandskombinationen eines Widerstandsarrays vom Prozessor 21 aus, um dadurch die Spannung der Triggerschwelle 20 in Grenzen qualitativ der Amplitudenschwankung des Analogsignales 13' nachzuführen. Dadurch wird erreicht, dass die Triggerschwelle 20 stets unter den aktuell höchsten Amplituden des Analogsignales 13' bleibt, um zuverlässig den Binärwert I durchschalten zu lassen, aber zur Ausgabe des Binärwertes 0 stets oberhalb der aktuell niedrigsten Amplituden 10 ansteht.

Um dieses Schaltungsverhalten zu stabilisieren, kann es zweckmäßig sein, für die Einstellung des Widerstandsarrays im Digitalpotentiometer 22 außer auf die aktuelle Amplitude 10 des Analogsignales 13' auch auf das daraus aktuell abgeleitete Digitalsignal 14 zurückzugreifen; wie im Blockschaltbild durch den Anschluss des Mikroprozessors 21 auch an den Schaltungs-Ausgang 15 veranschaulicht.

Vom Prozessor 21 wird ferner ein gleichartiges Widerstandsarray in einem weiteren Digitalpotentiometer 23 umgeschaltet, um den mittleren Pegel jeden Impulses im gefilterten Analogsignal 13 mittels des schon erwähnten Mittelwertstellers 18 durch Potentialüberlagerung auf möglichst etwa 50% der Betriebsspannung Vcc nachzuführen.

Eine Wandlerschaltung 12 zum Umsetzen der binärmodulierten Impulsfolge 10-10 eines empfangenen Analogsignales 13 in den Bitstrom eines weiterzuverarbeitenden Digitalsignales 14 kann auch noch verrauschte, schwache Analogsignale 13 vergleichsweise zuverlässig umwandeln und dadurch auch noch Datentelegramme von schwächeren oder entfernteren Sendern verarbeiten, indem also erfindungsgemäß die Triggerschwelle 20 ihres Ausgangs-Komparators 19 den Amplituden jedes einzelnen Impulses 10 in der Bitfolge des aktuell empfangen Telegramms nachgefahren wird. Dafür tastet ein Mikroprozessor 21 die Maximal- und die Minimal-Amplituden im Analogsignal 13 ab, um das Widerstandsarray in einem Digitalpotentiometer 22 für die Folgesteuerung der Triggerschwelle 20 ständig feinstufig entsprechend umzuschalten. Zweckmäßigerweise wird aus den selben Amplitudenwerten vom Mikroprozessor 21 noch ein weiteres Digitalpotentiometer 23 angesteuert, das dem Analogsignal 13 während seines Empfangs in einem als Mittelwertsteller 18 wirkenden Operationsverstärker einen Pegel derart überlagert, dass im Interesse hoher Aussteuerung der Gleichstrommittelwert im so konditionierten Analogsignal 13' für jedes Bit möglichst bei halber Betriebsspannung (50%Vcc) gehalten bleibt.

### Bezugszeichenliste

- 10: Impuls
- 11: Eingang (von 12, mit 13)
- 12: Wandlerschaltung (für 13 nach 14)
- 13: Analogsignal; 13' konditioniertes Analogsignal
- 14: Digitalsignal (bei 15)
- 15: Ausgang (von 12)
- 16: HF-Komponenten (in 13)
- 17: Tiefpass (gegen 16)
- 18: Mittelwertsteller (für 13)
- 19: Komparator (mit 13' gegen 20)
- 20: Triggerschwelle (für 13 an 19)
- 21: Mikroprozessor (für 20)
- 22: Digitalpotentiometer (zwischen 21 und 19)
- 23: Digitalpotentiometer (zwischen 21 und 18)

## Patentansprüche

1. Wandlerschaltung (12) zum Umwandeln eines empfangenen seriellen Analogsignales (13, 13') in den weiterzuverarbeitenden Bitstrom eines Digitalsignales (14) mittels eines Komparators (19) mit einstellbarer Triggerschwelle (20),
**dadurch gekennzeichnet,**
**dass** dem das Analogsignal (13) führenden Schaltungs-Eingang (11) ein Mittelwertsteller (18) zum Nachführen des mittleren Gleichspannungspegels im Analogsignal (13) auf etwa halber Betriebsspannung (50%Vcc) nachgeschaltet ist,
**dass** ein Mikroprozessor (21) zum Abtasten des Analogsignales (13, 13') zum Feststellen dessen Maximal- und Minimalamplituden sowie zum entsprechenden Ansteuern eines Digitalpotentiometers (22) zum Nachführen des Potentials der Triggerschwelle (20) vorgesehen ist,
wobei die Triggerschwelle (20) für jeden der im Analogsignal (13, 13') aufeinanderfolgenden Impulse (10) dessen Amplitude (û) nachgeführt ist.

2. Wandlerschaltung nach dem vorangehenden Anspruch,
**dadurch gekennzeichnet,**
**dass** der die Triggerschwelle (20) nachführende Mikroprozessor (21) außerdem dem Ausgang des Komparators (19) nachgeschaltet ist.

3. Wandlerschaltung nach dem vorangehenden Anspruch,
**dadurch gekennzeichnet,**
**dass** der Mittelwertsteller auch einem Mikroprozessor (21) zum Abtasten des Analogsignales (13) nachgeschaltet ist.

4. Wandlerschaltung nach dem vorangehenden Anspruch,
**dadurch gekennzeichnet,**
**dass** der Mittelwertsteller (18) zusätzlich zum Analogsignal (13) mit einer vom Mikroprozessor (21) über ein Digitalpotentiometer (23) veränderbaren Spannung beaufschlagt ist.

5. Wandlerschaltung nach einem der vorangehenden Ansprüche,
**dadurch gekennzeichnet,**
**dass** ihrem Eingang (11) ein Tiefpass (17) zum Ausfiltern von Hochfrequenzkomponenten (16) im Analogsignal (13) nachgeschaltet ist.

6. Verwendung einer Wandlerschaltung nach einem der vorangehenden Ansprüche zum drahtlosen Fernablesen von Energieversorgungs-Messgeräten wie Wärmemengen- oder Wasserverbrauchszählern in Mietwohnungen zur Kostenabrechnung.

## Claims

1. Converter circuit (12) for converting a received serial analogue signal (13, 13') into the bit stream of a digital signal (14) to be processed further by means of a comparator (19) with an adjustable trigger threshold (20),
**characterized**
**in that** a mean value controller (18) for tracking the mean DC voltage level in the analogue signal (13) at approximately half the operating voltage (50%Vcc) is connected downstream of the circuit input (11) carrying the analogue signal (13),
**in that** a microprocessor (21) is provided for the purpose of sampling the analogue signal (13, 13') in order to determine its maximum and minimum amplitudes and for the purpose of accordingly controlling a digital potentiometer (22) for tracking the potential of the trigger threshold (20),
the trigger threshold (20) being tracked to the amplitude (*û*) of each of the successive pulses (10) in the analogue signal (13, 13').

2. Converter circuit according to the preceding claim,
**characterized**
**in that** the microprocessor (21) tracking the trigger threshold (20) is also connected downstream of the output of the comparator (19).

3. Converter circuit according to the preceding claim,
**characterized**
**in that** the mean value controller is also connected downstream of a microprocessor (21) for sampling the analogue signal (13).

4. Converter circuit according to the preceding claim,
**characterized**
**in that**, in addition to the analogue signal (13), a voltage which can be changed by the microprocessor (21) via a digital potentiometer (23) is applied to the mean value controller (18).

5. Converter circuit according to one of the preceding claims,
**characterized**
**in that** a low-pass filter (17) for filtering out radio-frequency components (16) in the analogue signal (13) is connected downstream of the input (11) of said circuit.

6. Use of a converter circuit according to one of the preceding claims to wirelessly remotely read energy supply measuring devices such as heat or water consumption meters in rented apartments for the billing of costs.

## Revendications

1. Circuit convertisseur (12) destiné à convertir un signal analogique (13, 13') série reçu en le train binaire à soumettre à un traitement ultérieur d'un signal numérique (14) au moyen d'un comparateur (19) à seuil de déclenchement (20) réglable,
**caractérisé en ce**
**qu'**un élément de réglage de valeur moyenne (18) destiné à l'asservissement du niveau de tension continue moyen dans le signal analogique (13) à environ la moitié de la tension de service (50 %Vcc) est branché à la suite de l'entrée de circuit (11) qui conduit le signal analogique (13),
**qu'**il existe un microprocesseur (21) destiné à échantillonner le signal analogique (13, 13') en vue de définir ses amplitudes maximale et minimale ainsi que pour piloter en conséquence un potentiomètre numérique (22) afin d'asservir le potentiel du seuil de déclenchement (20),
le seuil de déclenchement (20) étant asservi à l'amplitude (û) de chaque impulsion (10) successive dans le signal analogique (13, 13').

2. Circuit convertisseur selon la revendication précédente, **caractérisé en ce que** le microprocesseur (21) qui asservit le seuil de déclenchement (20) est en plus branché à la suite de la sortie du comparateur (19).

3. Circuit convertisseur selon la revendication précédente, **caractérisé en ce que** l'élément de réglage de valeur moyenne est également branché à la suite d'un microprocesseur (21) destiné à échantillonner le signal analogique (13).

4. Circuit convertisseur selon la revendication précédente, **caractérisé en ce que** l'élément de réglage de valeur moyenne (18), en plus du signal analogique (13), est chargé avec une tension pouvant être modifiée par le microprocesseur (21) par le biais d'un potentiomètre numérique (23).

5. Circuit convertisseur selon l'une des revendications précédentes, **caractérisé en ce qu'**un filtre passe-bas (17) destiné à éliminer par filtrage les composantes à haute fréquence (16) dans le signal analogique (13) est branché à la suite de son entrée (11).

6. Utilisation d'un circuit convertisseur selon l'une des revendications précédentes pour le relevé à distance sans fil d'appareils de mesure de distribution d'énergie tels que des calorimètres ou des compteurs d'eau dans des logements en location en vue de la facturation des coûts.
